Europäisches Patentamt

**European Patent Office**

**Office européen des brevets**

(19)

(11) Veröffentlichungsnummer: **0 134 950**
**B1**

(12) **EUROPÄISCHE PATENTSCHRIFT**

(45) Veröffentlichungstag der Patentschrifft:
21.03.90

(21) Anmeldenummer: **84107612.8**

(22) Anmeldetag: **30.06.84**

(51) Int. Cl. ⁵: **H 03 H 7/48, H 01 F 17/00**

(54) **Hochfrequenz-Rohrkernübertrager mit in Drucktechnik ausgeführten Wicklungen.**

(30) Priorität: **13.08.83 DE 3329368**

(43) Veröffentlichungstag der Anmeldung:
**27.03.85 Patentblatt 85/13**

(45) Bekanntmachung des Hinweises auf die Patenterteilung:
**21.03.90 Patentblatt 90/12**

㊻ Bennante Vertragsstaaten:
**AT CH DE LI NL SE**

(56) Entgegenhaltungen:
**CH-A-468 065**
**DE-A-2 703 258**
**DE-B-2 445 982**
**GB-A-771 701**
**GB-A-1 040 071**
**GB-A-1 249 823**
**US-A-3 081 525**

**Die Akte enthält technische Angaben, die nach dem Eingang der Anmeldung eingereicht wurden und die nicht in dieser Patentschrift enthalten sind.**

(73) Patentinhaber: **Richard Hirschmann Radiotechnisches Werk**
**Richard-Hirschmann-Strasse 19 Postfach 110**
**D-7300 Esslingen a.N. (DE)**

(72) Erfinder: **Wendel, Wolfgang, Dipl.-Ing.**
**Steinbruchstrasse 62**
**D-7316 Köngen (DE)**

(74) Vertreter: **Stadler, Heinz, Dipl.-Ing.**
**Richard Hirschmann Radiotechnisches Werk Richard-Hirschmann-Strasse 19**
**D-7300 Esslingen a.N. (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBERGRAF, STOCKHOLM 1990

## Beschreibung

Die Erfindung betrifft einen Hochfrequenz-Rohrkernübertrager für auf einseitig kaschierten Trägerplatinen angeordnete Hochfrequenz-Schaltungen von Gemeinschafts-Antennenanlagen im VHF-/UHF-Bereich, insbesondere Verteiler und Abzweiger, bestehend aus einer senkrecht auf der unkaschierten Seite der Trägerplatine angeordneten Wicklungsplatine, die mit Randteilen in entsprechende Ausnehmungen der Trägerplatine einsteckbar ist und deren die Übertragerwicklungen bildende Leiterbahnen durch kurze korrespondierende Leiterbahnen der Trägerplatine zu geschlossenen Windungen verbunden sind.

Ein derartiger Übertrager ist bereits aus der CH-A-4 680 65 bekannt. Im Vergleich zu Hochfrequenz-Rohrkernübertragern, wie sie beispielsweise in der DE-B-2 445 982 und der DE-C-1 616 291 beschrieben sind, zeichnet er sich durch einen kompakten, umkomplizierten herstell- und montierbaren Aufbau aus, der sich auch für Tauchlötung eignet und damit eine kostengünstige Mengenfertigung erlaubt. Zudem eröffnet diese Konzeption einer Aufteilung in Träger- und Wicklungsplatine die Möglichkeit für ein einfaches Baukastensystem, bei dem mit unterschiedlichen Wicklungsplatinen ohne Werkzeugänderungen für die Trägerplatine Abzweiger und Verteiler in beliebiger Ausführung herstellbar sind. Andererseits sind mit diesem bekannten Hochfrequenz-Rohrkernübertrager zufriedenstellende elektrische Eigenschaften, insbesondere eine ausreichend geringe Durchgangsdämpfung und hohe Rückflußdämpfungen nur bei verhältnismäßig tiefen Frequenzen, nämlich maximal bis zum VHF-Bereich zu erzielen. Bei höheren Frequenzen im UHF-Bereich dagegen sind diese Werte schon für als Einzelbausteine verwendete Übertrager unbefriedigend und bei Mehrfachverwendung, z. B. bei Einsatz als Abzweiger in hintereinander geschalteten Antennensteckdosen, häufig unbrauchbar.

Der Erfindung liegt daher die Aufgabe zugrunde, einen Hochfrequenz-Rohrkernübertrager nach dem Oberbegriff mit möglichst geringem Aufwand derart weiterzubilden, daß unter Wahrung des Vorteils einer einfachen und kostengünstigen Massenfertigung auch von Übertragern mit großem Übersetzungverhältnis bei geringen Streuungen der elektrischen Werte bis zu den höchsten Frequenzen des UHF-Bereichs günstige Werte für die Durchgangs- und Anschlußdämpfung erreicht sind.

Diese Aufgabe ist erfindungsgemäß dadurch gelöst, daß die Wicklungsplatine (W) als E-Schnitt mit auf dem Mittelschenkel ($S_2$, $S_4$) angeordnetem Rohrkern ($K_1$, $K_2$) ausgebildet ist und ihre Übertragerwicklungen von einer Metallfläche (M) umfaßt sind, deren Endteile mit dem Massebelag der Trägerplatine (T) galvanisch verbunden sind und deren Abstand von den äußeren Wicklungsleiterbahnen kleiner als deren Breite so gewählt ist, daß die Kapazität zwischen Metallfläche (M) und den äußeren Wicklungsleiterbahnen mit der Streuinduktivität der Übertrager jeweils einen Resonanzkreis bildet, dessen Resonanzfrequenz im oberen Betriebsfrequenzbereich liegt.

Die den Hochfrequenz-Rohrkernübertrager umfassende, ohne Mehraufwand in der Mengenfertigung herstellbare Metallfläche bildet zugleich eine verteilte Kapazität zur breitbandigen Kompensation der Streuinduktivität und eine Abschirmung des Übertragers, welche schädliche Verkopplungen mit anderen Schaltungsteilen und Verluste durch Abstrahlung verhindert. Damit ist auf einfache und kostengünstige Weise nicht nur eine wesentliche Anhebung der oberen Grenzfrequenz erreicht, sondern zudem eine Verbesserung der Werte für die Durchgangsund Rückflußdämpfung im VHF-Bereich, so daß sich der erfindungsgemäße Hochfrequenz-Rohrkernübertrager vorallem auch für den Einsatz in kaskadierten Geräten wie Antennensteckdosen über einen sehr großen Frequenzbereich eignet.

In den Unteransprüchen sind Weiterbildungen und vorteilhafte Ausgestaltungen der Erfindung beschrieben.

Der erfindungsgemäße Hochfrequenz-Rohrkernübertrager kann nach Anspruch 2 im Bedarfsfalle sehr einfach und kostensparend zu einstückigen Mehrfachübertragern, beispielsweise für Vielfach-Richtkoppler-Abzweiger, zusammengefaßt werden, wodurch eine wesentliche Vereinfachung der Fertigung der Wicklungsplatine, sowie ihrer Montage auf der Trägerplatine erreicht ist. Dabei ergibt sich in vorteilhafter Weise eine kurze Länge der Wicklungsplatine, wenn die Metallfläche gemäß Anspruch 3 die außenliegenden Teile der äußeren Leiterbahnen mehrerer Übertrager gemeinsam umfaßt, weil dann die jeweils gemeinsamen Schenkel zweier aneinander liegender Übertrager nur die Leiterbahnen aufzunehmen haben und somit eine geringe Breite aufweisen können. Dabei dürfte mit Rücksicht auf ausreichende elektrische Daten im oberen Teilfrequenzbereich die Grenze bei jeweils drei derart zusammengefaßten Übertragern liegen.

Bei einem Hochfrequenz-Rohrkernübertrager nach Anspruch 4 ist, wie z. B. aus der DE-C-2 703 258 bekannt, auf einfache Weise für den gesamten Betriebsfrequenzbereich die Stammdurchgangsdämpfung und Rückflußdämpfung für alle Anschlüsse verbessert. Aus der gleichen Veröffentlichung ist es bekannt, zu weiterer Verringerung der Stammdurchgangsdämpfung die Windungen des Stromübertragers gleichmäßig am Umfang des Rohrkerns zu verteilen, was beispielsweise mit dem in Anspruch 5 angegebenen Aufbau der Wicklungsplatine erreichbar ist. Eine noch günstigere Windungsverteilung ist jedoch mit einer Ausführung gemäß Anspruch 6 zu erzielen, weil dabei eine dünnere und damit kostengünstigere Platine verwendbar und beim Stromübertrager die doppelte Windungszahl (mehr Anwendungsmöglichkeiten) realisierbar ist.

Die Figuren zeigen ein Ausführungsbeispiel des erfindungsgemäßen Hochfrequenz-Rohrkernübertragers bei einem im Frequenzbereich 0,15 - 860 MHz arbeitenden Richtkopplerabzweiger für eine Antennensteckdose.

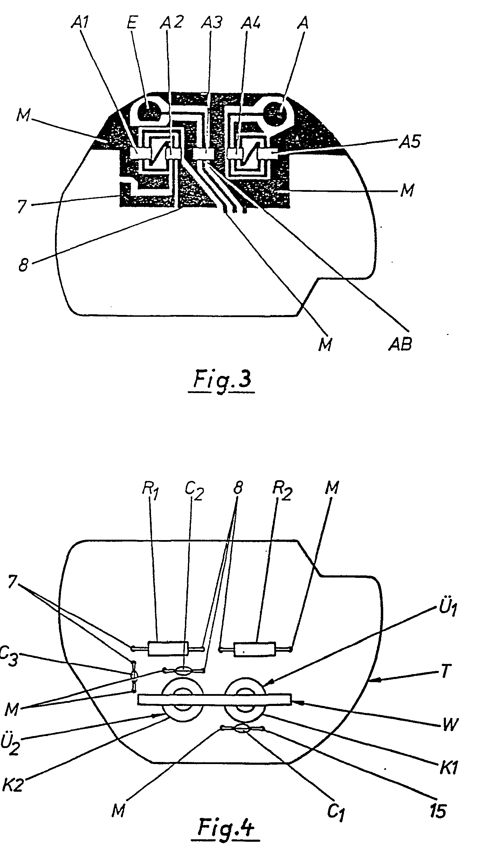

Dabei ist in Fig. 1 das Schaltbild des Abzweigers, in Fig. 2 a eine teilweise geschnittene Ansicht einer der beiden identisch ausgebildeten Seiten mit Rohrkernen bestückten Wicklungsplatine, in Fig. 2 b ein Schnitt durch die freien Endteile der Schenkel dieser Wicklungsplatine (jeweils in vergrößertem Maßstab) und in den Fig. 3 und 4 jeweils eine Ansicht der kaschierten bzw. der unkaschierten Seite der Trägerplatine dargestellt, wobei der Übersichtlichkeit halber das für die Erfindung unwichtige am Abzweig angeschlossene Filter zum Auftrennen des Frequenzbereiches in den Rundfunk- und Fernsehbereich weggelassen ist.

Der Richtkoppler weist zwei getrennte identische Übertrager $\ddot{U}_1$ und $\ddot{U}_2$ auf. Die Primärwicklung des Stromübertragers $\ddot{U}_1$ ist direkt zwischen den Eingang E und den Ausgang A des Abzweigers in die Stammleitung eingeschaltet. Seine Sekundärwicklung ist einmal am Abzweiganschluß AB und zum andern über einen Kondensator $C_1$ an Masse M angeschlossen.

Die Primärwicklung des Spannungsübertragers $\ddot{U}_2$ ist einerseits mit dem Eingang E und mit dem zweiten Anschluß zugleich über zwei hintereinander geschaltete Widerstände $R_1$, $R_2$ und über einen dazu parallelen Kondensator $C_3$ mit Masse M verbunden.

Die Sekundärwicklung des Spannungsübertragers $\ddot{U}_2$ ist zwischen dem Abzweiganschluß AB und dem Verbindungspunkt der beiden Widerstände $R_1$, $R_2$ eingeschaltet, der seinerseits über einen Kondensator $C_2$ an Masse M liegt. Im oberen Übertragungsbereich (40 - 860 MHz), in dem der Richtkoppler wirksam ist, stellen die Kondensatoren $C_1$, $C_3$ praktisch Kurzschlüsse dar, sodaß ein klassischer Richtkopplerabzweiger vorliegt, bei dem lediglich der interne Richtkopplerabschlußwiderstand durch die Parallelschaltung der Widerstände $R_1$, $R_2$ gebildet und der Kondensator $C_2$ als Kompensationskapazität zur Erhöhung der oberen Grenzfrequenz hinzugeschaltet ist.

Die Kondensatoren $C_1$, $C_3$ bilden zusammen mit den Induktivitäten der Sekundärwicklung des Stromübertragers $\ddot{U}_1$ bzw. der Primärwicklung des Spannungsübertragers $\ddot{U}_2$ jeweils einen Serienresonanzkreis; diese Resonanzkreise sind so bemessen, daß ihre Resonanzfrequenz zwischen dem oberen und dem unteren Übertragungsbereich (0,15 - 26,1 MHz) liegt.

Im unteren Frequenzbereich wirken die Kondensatoren als Sperren und die Übertragerwicklungen praktisch als Kurzschlüsse, sodaß die Widerstände $R_1$, $R_2$ für die zum Abzweiganschluß AB gelangenden Signale einen Spannungsteiler zur Erzeugung der notwendigen Abzweigdämpfung darstellen.

Alle angeführten Bauteile dieses Richtkoppler-Abzweigers sind auf der unkaschierten Seite einer einseitig kaschierten Trägerplatine T angeordnet und auf deren anderer Seite durch entsprechende Masseflächen bzw. Leiterbahnen gemäß der beschriebenen Schaltung im kostengünstigen Tauchlötverfahren miteinander verbunden.

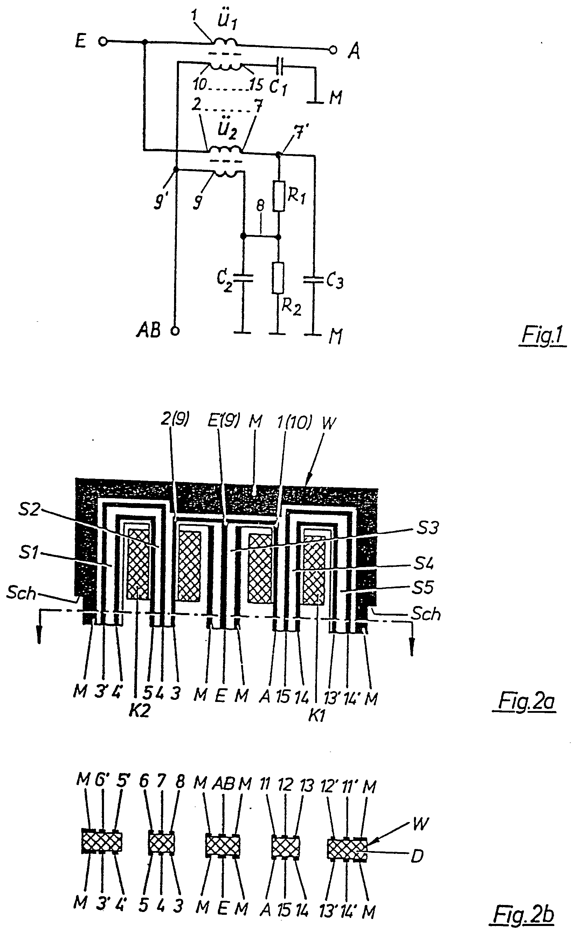

Der Stromübertrager $\ddot{U}_1$ und der Spannungsübertrager $\ddot{U}_2$ sind als Rohrkernübertrager mit als gedruckte Leiterbahnen gemeinsam auf den beiden Seiten einer als doppelseitig kaschierte Isolierstoffplatte D aufgebauten Wicklungsplatine W ausgebildeten Wicklungen ausgeführt. Diese weist fünf von einem Längsabschnitt abragende, zueinander parallele gleich lange Schenkel S 1 bis S 5 auf, auf deren zweiten und vierten die beiden Rohrkerne K 1, K 2 aufgesteckt sind und deren Endteile entsprechende Ausnehmungen A 1 bis A 5 der Trägerplatine T von deren unkaschierter Seite her bis zu Schultern Sch der Schenkel S 1 und S 5 durchsetzen. Die Windungsteile 2 - 3, 3' - 4, 4' - 5, 5' - 6, 6' - 7, sowie 10' - 11, 11' - 12, 12' - 13, 13' - 14, 14' - 15 der Wicklungsplatine W sind nach dem Tauchlöten über Leiterbahnen 3 -3', 4 - 4', 5 - 5', 6 - 6' bzw. 11 - 11', 12 - 12', 13 - 13', 14 - 14' der Trägerplatine T kreuzungsfrei, d.h. ohne zusätzliche Drahtbrücken zur vollständigen Sekundärwicklung des Spannungsübertragers $\ddot{U}_2$ bzw. Primärwicklung des Stromübertragers $\ddot{U}_1$ verbunden (in Fig. 2 a geben die eingeklammerten Ziffern entsprechende Punkte auf der Platinenrückseite an). Die Primärwicklung des Stromübertragers $\ddot{U}_1$, sowie die Sekundärwicklung des Spannungsübertragers $\ddot{U}_2$ sind durch die Leiterbahnen 1 - A bzw. 8 - 9 gebildet.

Die außen liegenden Teile der äußeren Windungen auf der Wicklungsplatine W und der kaschierten Seite der Trägerplatine T sind jeweils in einem Abstand von einer Massefläche M umgeben, der geringer ist als die Leiterbahnbreite. Auf diese Weise bildet die Kapazität zwischen diesen Metallteilen zusammen mit der Streuinduktivität der Wicklungen jeweils einen Resonanzkreis mit im oberen UHF-Bereich liegender Resonanzfrequenz. Die so erzeugte Resonanzüberhöhung bewirkt auf einfache Weise eine Heraufsetzung der oberen Grenzfrequenz auf 860 MHz.

Die Leitung vom Eingang E zum Verzweigungspunkt E' ist ebenso wie diejenigen zwischen 9' und AB (sowie von dort zu dem nicht dargestellten Filter) und zwischen 13' und A derart von Masseflächen umgeben, daß eine wellenwiderstandsrichtige Signalübertragung gewährleistet ist. Die Leiterbahnen bzw. Masseflächen zur Verbindung der Übertragungsanschlüsse mit den entsprechenden Bauelementen sind ebenfalls kreuzungsfrei ausgeführt.

**Patentansprüche**

1. Hochfrequenz-Rohrkernübertrager für auf einseitig kaschierten Trägerplatinen angeordnete Hochfrequenz-Schaltungen von Gemeinschafts-Antennenanlagen im VHF-/UHF-Bereich, insbesondere Verteiler und Abzweiger, bestehend aus einer senkrecht auf der unkaschierten Seite der Trägerplatine angeordneten Wicklungsplatine, die mit Randteilen in entsprechende Ausnehmungen der Trägerplatine einsteckbar ist und deren die Übertragerwicklungen bildende Leiterbahnen durch kurze korrespondierende Leiterbahnen der Trägerplatine zu geschlossenen Windungen verbunden sind, *dadurch gekennzeichnet*, daß die Wicklungsplatine (W) als E-Schnitt mit auf dem Mittelschenkel (S2, S4) angeordnetem Rohrkern (K1, K2) ausgebildet ist und ihre Übertragerwicklungen von einer Metallfläche (M) umfasst sind, deren Endteile mit dem Massebelag der Trägerplatine (T) galvanisch verbunden sind und deren Abstand von den äußeren Wicklungsleiterbahnen kleiner als deren Breite so gewählt ist, daß die Kapazität zwischen Metallfläche (M) und den äußeren Wicklungsleiterbahnen mit der Streuinduktivität der Übertrager jeweils einen Resonanzkreis bildet, dessen Resonanzfrequenz im oberen Betriebsfrequenzbereich liegt.

2. Hochfrequenz-Rohrkernübertrager nach Anspruch 1, dadurch gekennzeichnet, daß wenigstens zwei Wicklungsplatinen (W) zu einem einstückigen Mehrfachübertrager zusammengefaßt sind.

3. Hochfrequenz-Rohrkernübertrager nach Anspruch 2, dadurch gekennzeichnet, daß die Metallfläche (M) die außen liegenden Teile der äußeren Leiterbahnen mehrerer Übertrager (Ü1, Ü2) gemeinsam umfaßt.

4. Hochfrequenz-Rohrkernübertrager nach Anspruch 1 oder 2, dadurch gekennzeichnet, daß die die Rohrkerne aufnehmenden Schenkel (S2, S4) der Wicklungsplatine (W) für zwei Übertrager eines Richtkopplers, sowie die zugehörigen Rohrkerne (K1, K2) derart entsprechend unterschiedliche Längen aufweisen, daß das Rohrkernvolumen des Stromübertragers (Ü1) kleiner ist als dasjenige des Spannungsübertragers (Ü2).

5. Hochfrequenz-Rohrkernübertrager nach Anspruch 4, dadurch gekennzeichnet, daß die Stärke der Wicklungsplatine (W) bzw. des den Stromübertrager (Ü1) bildenden Teils etwa der Schenkelbreite entspricht.

6. Hochfrequenz-Rohrkernübertrager nach Anspruch 4, dadurch gekennzeichnet, daß quer zu dem den Stromübertrager (Ü1) bildenden Teil der Wicklungsplatine (W) eine weitere E-förmige Wicklungsplatine derart angeordnet ist, daß die Mittelschenkel (S2) beider Platinen durch ineinandergreifende Längsschlitze zusammengesteckt sind.

**Revendications**

1. Circuit répartiteur de signaux HF comportant un noyau tubulaire, pour circuits haute fréquence disposés sur des plaques-supports doublées d'un seul côté et destinés à des antennes collectives dans la gamme VHF/UHF, en particulier distributeur et déviateur, composé d'une platine à enroulement disposée perpendiculairement sur la face non doublée de la plaque-support, pouvant, grâce à ses bords, s'enficher dans des creux adaptés de la plaque-support et dont les pistes conductives formant les enroulements du circuit répartiteur sont reliées en formant des spires fermées, par de courtes pistes conductives correspondantes de la plaque-support, *caractérisé* en ce que la plaque à enroulement (W) est conçue sous forme d'une coupe en E, avec un noyau tubulaire (K1, K2) disposé sur le montant central (S2, S4) et en ce que ses enroulements du circuit répartiteur sont entourés par une surface métallique (M) dont les extrémités sont reliées galvaniquement au garnissage de masse de la plaque-support (T) et dont la distance avec les pistes conductives extérieures des enroulements est choisie plus petite que sa largeur, de manière à ce que la capacité entre la surface métallique (M) et les pistes conductives extérieures de l'enroulement forme avec l'inductance de fuite des circuits répartiteurs un circuit résonnant dont la fréquence de résonance se situe dans la gamme haute de la fréquence de travail

2. Circuit répartiteur de signaux HF comportant un noyau tubulaire selon la revendication 1, caractérisé en ce'qu au moins deux plaques à enroulement (W) sont regroupées en un circuit répartiteur mutiple monobloc.

3. Circuit répartiteur de signaux HF comportant un noyau tubulaire selon la revendication 2, caractérisé en ce que la surface métallique (M) entoure simultanément les parties extérieures des pistes conductives extérieures de plusieurs circuits répartiteurs (Ü1, Ü2).

4. Circuit répartiteur de signaux HF comportant un noyau tubulaire selon la revendication 1 ou 2, caractérisé en ce que d'une part, les montants (S2, S4) de la plaque a enroulement (W) qui reçoivent les noyaux tubulaires pour deux circuits répartiteurs d'un coupleur directif, d'autre part les noyaux tubulaires correspondants (K1, K2) présentent des longueurs différentes, de telle manière que le volume du noyau tubulaire du circuit répartiteur de courant (Ü1) est plus petit que celui du circuit répartiteur d'intensité (Ü2).

5. Circuit répartiteur de signaux HF comportant un noyau tubulaire selon la revendication 4, caractérisé en ce que l'épaisseur de la plaque à enroulement (W) ou de la partie formant le circuit répartiteur de courant (Ü1) correspond à peu près à la largeur du montant.

6. Circuit répartiteur de signaux HF comportant noyau tubulaire selon la revendication 4, caractérisé en ce que, transversalement à la partie de la plaque à enroulement (W) formant le circuit répartiteur de courant (Ü1), une autre plaque à en-

7

roulement en forme de E est disposée de manière à ce que les montants centraux (S2) des deux plaques sont assemblés par des fentes longitudinales s'engrenant l'une dans l'autre.

**Claims**

1. High-frequency directional coupler comprising a tubular core for high-frequency circuits, disposed on support plates lined on one side, of community antenna systems in the VHF/UHF range, in particular distributors and splitters, comprising a coil plate vertically disposed on the unlined side of the support plate, which coil plate can be inserted with parts of its rim into corresponding recessess of the support plate and the tracks of which coil plate, forming the repeater coils, are connected by short corresponding tracks of the support plate to make closed coils, *characterized* in that the coil plate (W) is in the form of an E-shaped profile, with the tubular core ($K_1$, $K_2$) disposed on the center leg ($S_2$, $S_4$), and that its repeater coils are enclosed by a metal surface (M), the end sections of which are electrically connected with the ground coating of the support plate (T) and the distance from the outer coil tracks or which is selected to be less than their width, such that the capacitance between the metal surface (M) and the outer coil tracks, together with the leakage inductance of the repeaters, forms a resonant circuit, the resonant frequency of which lies in the upper range of the operating frequency.

2. High-frequency directional coupler comprising a tubular core in accordance with claim 1, characterized in that at least two coil plates (W) are combined into a one-piece multiple repeater.

3. High-frequency directional coupler comprising a tubular core in accordance with claim 2, characterized in that the metal surface (M) simultaneously encloses the outwardly located parts of the outer tracks of several repeaters ($Ü_1$, $Ü_2$).

4. High-frequency directional coupler comprising a tubular core in accordance with claim 1 or 2, characterized in that the legs (S2, S4) of the coil plate (W), which receive the tubular core for two repeaters of a directional coupler, and the associated tubular cores (K1, K2) have such correspondingly different lengths that the tubular core volume of the current repeater ($Ü_1$) is smaller than that of the voltage repeater ($Ü_2$).

5. High-frequency directional coupler comprising a tubular core in accordance with claim 4, characterised in that the thickness of the coil plate (W), or of the part forming the current repeater ($Ü_1$), is approximately equivalent to the leg width.

6. High-frequency directional coupler comprising a tubular core in accordance with claim 4, characterized in that a further E-shaped coil plate is disposed transversely to the part of the coil plate (W) which forms the current repeater ($Ü_1$), such that the center leg (S2) of both plates are plugged together by means of interlocking longitudinal slits.

*Fig.1*

*Fig.2a*

*Fig.2b*

_Fig.3_

_Fig.4_